# EUROPÄISCHE PATENTSCHRIFT

(11) **EP 0 882 308 B1**
(45) Veröffentlichungstag und Bekanntmachung des Hinweises auf die Patenterteilung: **11.02.2004**
(21) Anmeldenummer: 97951061.7
(22) Anmeldetag: 11.11.1997
(51) Int. Cl.: H01L 23/495

(54) **OPTIMIERUNG DER LEISTUNGSVERBINDUNG ZWISCHEN CHIP UND LEITERRAHMEN FÜR LEISTUNGSSCHALTER**
OPTIMIZING THE POWER CONNECTION BETWEEN CHIP AND CIRCUIT BOARD FOR A POWER SWITCH
OPTIMISATION DE LA CONNEXION DE PUISSANCE ENTRE UNE PUCE ET UN CADRE CONDUCTEUR POUR SECTIONNEUR DE PUISSANCE

(30) Priorität: 11.11.1996 DE 19646472
(43) Veröffentlichungstag der Anmeldung: 09.12.1998
(73) Patentinhaber: Infineon Technologies AG, 81669 München (DE)
(72) Erfinder: SANDER, Rainald, D-81379 München (DE); XU, Chihao, D-81249 München (DE)
(74) Vertreter: Patentanwälte Westphal, Mussgnug & Partner
(86) Internationale Anmeldenummer: PCT/DE1997/002631
(87) Internationale Veröffentlichungsnummer: WO 1998/021751

(56) Entgegenhaltungen:
- EP-A- 0 418 749
- EP-A- 0 446 937
- , PROFET [ONLINE], UPDATED 4 MARCH 1997 , AVAILABLE FROM INTERNET:<URL:HTTP://WWW.SIEMENS.DE/SEMICO NDUCTOR/PRODUCTS/36/3634.HTM XP002063574 siehe Seite 1-1; Abbildung 1.1
- ZOLLO S: "THE BOOM STARTS IN SMART POWER PRODUCTS" 24.Juli 1986 , ELECTRONICS, VOL. 59, NR. 27, PAGE(S) 97 - 101 XP000051602 siehe Seite 98 - Seite 99; Abbildung 3
- MOTOROLA: "BEILAGE KOMPASS NR. 29, SMARTMOS-TECHNOLOGIE: WAS MACHT MOTOROLA?" 19.Oktober 1993 , ELEKTRONIK, VOL. 42, NR. 21 XP002063575 siehe das ganze Dokument
- VAN TREEK G ET AL: "HOCHSTROM-MOTORTREIBER-ICS EIN SCHRITT ZUR MULTIPLEXTECHNIK IM AUTO" 9.Juli 1991 , ELEKTRONIK, VOL. 40, NR. 14, PAGE(S) 58 - 61 XP000241415 siehe Seite 58 - Seite 59; Abbildungen 1B,3
- "SMART-POWER ICS" 31.März 1988 , EDN ELECTRICAL DESIGN NEWS, VOL. 33, NR. 7, PAGE(S) 113 - 120, 122, 124, 126 XP000118770 siehe das ganze Dokument

## Beschreibung

Die Erfindung betrifft ein Halbleiterbauelement bestehend aus einem integrierten Halbleiterchip mit wenigstens einem Leistungs-MOSFET oder einem Leistungs-Bipolartransistor und einem Signalverarbeitungsschaltkreis, welcher ein Schwachstromsignal verarbeitet, wobei jeder Schaltkreis Anschlußflächen aufweist, die mit einem Leiterrahmen über eine Vielzahl von Bonddrähten verbunden sind.

Ein solches Halbleiterbauelement ist beispielsweise aus der EP 0 446 937 B1 bekannt.

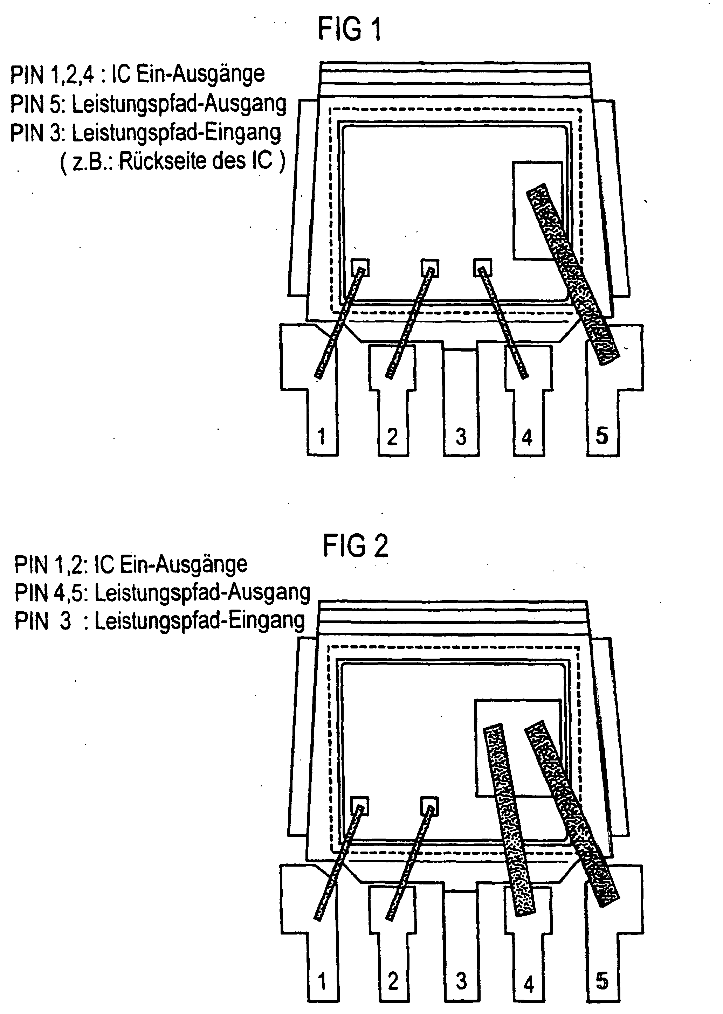

Die dort gezeigten Halbleiterbauelemente (Figur. 1 und 2) sind in der Regel niederohmige Halbleiterschalter, bei denen der Widerstand der Leitungsverbindung zwischen dem Halbleiterchip und dem Leiterrahmen nicht mehr vernachlässigbar ist. Diese Leitung begrenzt auch den maximal zulässigen Laststrom.

Des weiteren weist die Metallisierung, die den Leistungstransistor mit dem Bonddraht verbindet, aufgrund der großen Fläche des Halbleiterchips einen deutlichen Widerstandsanteil auf. Da die Stromdichte in der Metallisierung um den Bondkontakt sehr groß ist, führt dies außerdem zu einer inhomogenen Temperaturverteilung auf dem Chip und zu einer Reduktion der Lebensdauer des Chips.

Die aus dem Stand der Technik bekannten Lösungen sehen für die Leitungsverbindung einen oder mehrere Bonddrähte vor, welche alle auf den äußeren Leiterrahmen kontaktiert sind. Die Anzahl und Dicke der Bonddrähte richtet sich nach dem Durchlaßwiderstand des Halbleiterschalters und der verfügbaren Bondfläche auf den Leiterrahmen.

Wenn nur ein Bonddraht verwendet wird, sind sowohl der Widerstand des Bonddrahtes als auch der Widerstand der Metallisierung am größten. Wenn zwei Kontaktstellen auf dem Leiterrahmen bzw. zwei Bonddrähte verwendet werden, so ist das Ergebnis immer noch unbefriedigend.

Die Einzugsfläche der Bonddrähte sind stark unterschiedlich, so daß die Ausnutzung des Halbleiterchips reduziert wird. Die Stromführung durch die beiden Bonddrähte sind ebenfalls asymmetrisch, so daß der gesamt zulässige Laststrom durch die Bonddrähte nicht linear ansteigt.

Aufgabe der vorliegenden Erfindung ist es daher ein Halbleiterbauelement der eingangs genannten Art dahingehend weiter zu verbessern, daß eine wesentlich bessere Leitungsverbindung zwischen dem Leistungsteil eines Halbleiterschalters und dem Leiterrahmen hergestellt werden kann.

Erfindungsgemäß wird diese Aufgabe dadurch gelöst, daß der Leistungs-MOSFET oder der Leistungs-Bipolartransistor einen Eingang/Ausgang auf der Rückseite des Halbleiterchips aufweist und auf der Vorderseite zwei symmetrisch angeordnete Ausgänge/Eingänge aufweist und daß die symmetrisch angeordneten Ausgänge/Eingänge auf der Vorderseite auf beiden Seiten des Leiterrahmens symmetrisch mit Bonddrähten verbunden werden. Dadurch wird eine deutlich bessere Verbindung hergestellt. Die Optimierung dieser Verbindung, die in der Figur 8 gezeigt ist, erfolgt über die Bonddrähte auf beiden Seiten des Leiterrahmens, die symmetrisch sind und das Halbleiterchip in zwei Hälften teilen. Die Länge der Bonddrähte ist gleich und kürzer als bei der aus dem Stand der Technik bekannten asymmetrischen Verbindung, da der Chip von zwei Seiten angebondet wird.

Der Vorteil dieser Leitungsverbindung liegt in der besseren Stromaufteilung auf dem Halbleiterchip durch die bei dieser Konfiguration optimal möglichen Positionierung des Bondkontaktes auf der Metallisierungsschicht des Chips. Da die Ströme durch die Bonddrähte gleich sind, steigt der gesamt zulässige Laststrom durch die Bonddrähte linear an. Der Bonddrahtwiderstand wird reduziert. Insgesamt.ergibt diese Verbindung einen deutlich reduzierten Durchlaßwiderstand und eine höhere Belastbarkeit bei sonst gleicher Voraussetzung.

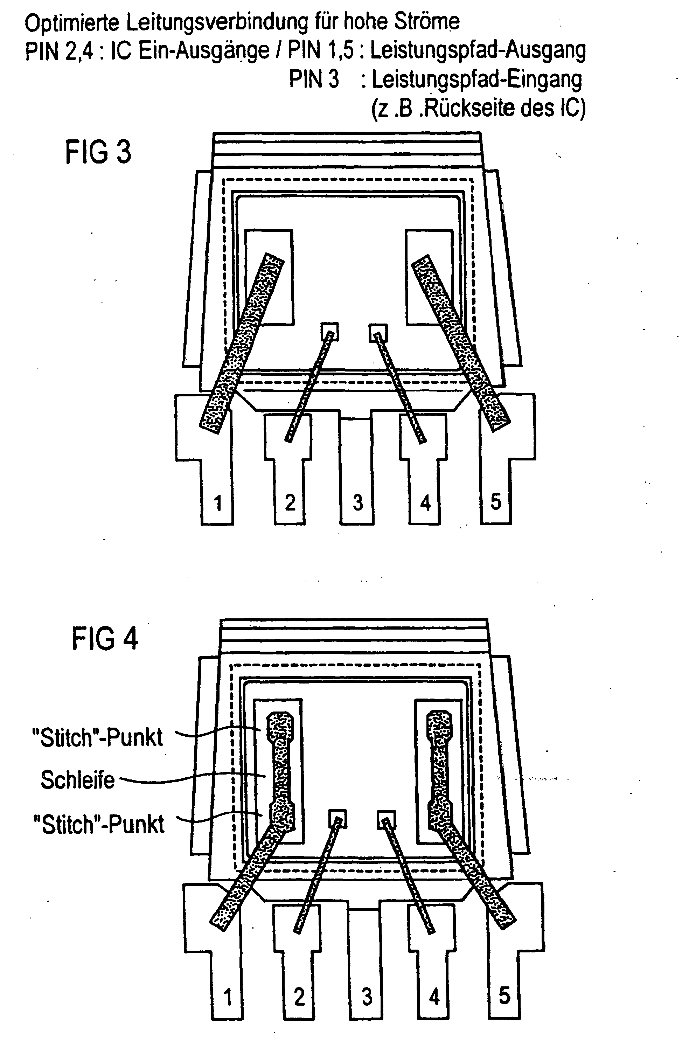

Vorzugsweise kann bei der Verwendung von sehr großen Halbleiterchips "Multiple Stitching" beim Bonden verwendet werden, daß heißt, daß der Bonddraht nicht nur einen, sondern mehrere Kontakte auf dem Halbleiterchip (Figur 4) aufweist. Dadurch ist die Einzugsfläche für jeden Kontakt heruntergeteilt und der Metallisierungswiderstand stark reduziert. Die effektive Länge des Bonddrahtes ist kleiner, da der gesamte Strom durch den Draht erst ab dem letzten Kontakt fließt.

Die symmetrische Gestaltung (Figur 3 und 4) der Leitungsverbindung erlaubt darüber hinaus eine sichere Kontrolle der Kontaktqualität von Bonddraht zu Leiterrahmen und Halbleiterchip. Ein Beispiel zur Kontrolle der Kontaktqualität ist das Ausmessen des Durchlaßwiderstandes nur über jeweils eine Bonddrahtverbindung. Ein Unterschied in diesen beiden Meßgrößen ist dann eine direkte Aussage über die Qualität der erzielten Bondverbindung.

Insgesamt läßt sich mit dem Halbleiterbauelement nach der vorliegenden Erfindung ein Leistungs-IC herstellen, das einen reduzierten.Durchlaßwiderstand aufweist, eine erhöhte Belastbarkeit sowie eine erhöhte Testbarkeit und eine erhöhte Lebensdauer aufweist.

## Patentansprüche

1. In einem Halbleiterchip integrierter Halbleiterschalter, wobei der Halbleiterchip eine Rückseite und eine Vorderseite aufweist und wobei an der Vorderseite zwei symmetrisch angeordnete Stromanschlüsse vorgesehen sind, die symmetrisch über zwei gleich lange Bond-Drähte an einen Leitungsrahmen angeschlossen sind, und wobei die Rückseite des Halbleiterchips ebenfalls an den Leitungsrahmen angeschlossen ist.

## Claims

1. Semiconductor switch which is integrated in a semiconductor chip, with the semiconductor chip having a rear face and a front face, and with two symmetrically arranged power connections being provided on the front face, which are connected symmetrically via two bonding wires of equal length to a leadframe, and with the rear face of the semiconductor chip likewise being connected to the leadframe.

## Revendications

1. Interrupteur à semi-conducteur intégré dans une puce de semi-conducteurs, dans lequel la puce de semi-conducteurs présente un côté arrière et un côté avant, avec sur le côté avant deux raccordements de courant disposés symétriquement et raccordés symétriquement à un cadre conducteur par deux fils d'interconnexion de même longueur, le côté arrière de la puce de semi-conducteurs étant également raccordé au cadre conducteur.
